# EUROPÄISCHE PATENTSCHRIFT

(11) **EP 1 230 672 B1**
(45) Veröffentlichungstag und Bekanntmachung des Hinweises auf die Patenterteilung: **21.01.2009**
(21) Anmeldenummer: 00985028.0
(22) Anmeldetag: 14.11.2000
(51) Int. Cl.: H01L 21/28

(54) **VERFAHREN ZUR BEHANDLUNG EINER OBERFLÄCHE EINER SIC-HALBLEITERSCHICHT UND KONTAKTHERSTELLUNG**
METHOD FOR TREATING A SURFACE OF AN SIC SEMICONDUCTOR LAYER AND FORMING A CONTACT
PROCEDE DE TRAITEMENT DE LA SURFACE D'UNE COUCHE SEMI-CONDUCTRICE EN SIC ET DE FORMATION D'UN CONTACT

(30) Priorität: 15.11.1999 DE 19954866
(43) Veröffentlichungstag der Anmeldung: 14.08.2002
(73) Patentinhaber: Infineon Technologies AG, 81669 München (DE)
(72) Erfinder: BARTSCH, Wolfgang, 91054 Erlangen (DE); TREU, Michael, A-9500 Villach (AT); RUPP, Roland, 91207 Lauf (DE)
(74) Vertreter: Bickel, Michael
(86) Internationale Anmeldenummer: PCT/EP2000/011260
(87) Internationale Veröffentlichungsnummer: WO 2001/037328

(56) Entgegenhaltungen:
- DE-A- 19 507 130
- US-A- 4 981 551
- US-A- 5 895 260
- CONSTANTINIDIS G ET AL: "Diffusion of gold in 3C-SiC epitaxially grown on Si structural characterization" MATERIALS SCIENCE AND ENGINEERING B,CH,ELSEVIER SEQUOIA, LAUSANNE, Bd. 46, Nr. 1-3, 1. April 1997 (1997-04-01), Seiten 186-189, XP004085309 ISSN: 0921-5107
- MARINOVA TS ET AL: "Nickel based ohmic contacts on SiC" MATERIALS SCIENCE AND ENGINEERING B,CH,ELSEVIER SEQUOIA, LAUSANNE, Bd. 46, Nr. 1-3, 1. April 1997 (1997-04-01), Seiten 223-226, XP004085316 ISSN: 0921-5107
- SHOR J S ET AL: "HIGH TEMPERATURE OHMIC CONTACT METALLIZATIONS FOR N-TYPE 3C-SIC" JOURNAL OF THE ELECTROCHEMICAL SOCIETY,US,ELECTROCHEMICAL SOCIETY. MANCHESTER, NEW HAMPSHIRE, Bd. 141, Nr. 2, 1. Februar 1994 (1994-02-01), Seiten 579-581, XP000450667 ISSN: 0013-4651
- TERAJI T ET AL: "IDEAL OHMIC CONTACT TO N-TYPE 6H-SIC BY REDUCTION OF SCHOTTKY BARRIER HEIGHT" APPLIED PHYSICS LETTERS,US,AMERICAN INSTITUTE OF PHYSICS. NEW YORK, Bd. 71, Nr. 5, 4. August 1997 (1997-08-04), Seiten 689-691, XP000699634 ISSN: 0003-6951
- TANG S M ET AL: "TITANIUM SILICIDE OHMIC CONTACTS FOR HIGH TEMPERATURE S-SIC DEVICES" EXTENDED ABSTRACTS,US,ELECTROCHEMICAL SOCIETY. PRINCETON, NEW JERSEY, Bd. 88-2, 21. September 1988 (1988-09-21), Seite 680 XP000050447 ISSN: 0160-4619

## Beschreibung

Die vorliegende Erfindung betrifft ein Verfahren zur Behandlung einer Oberfläche einer epitaktisch hergestellten SiC-Halbleiterschicht, bei dem auf dieser Oberfläche nach der Epitaxie eine Metallschicht als Kontakt aufgetragen wird.

Die Eigenschaften von SiC-Schottkydioden hängen weitgehend von dem Zustand der Oberfläche eines SiC-Halbleiterkörpers vor der Abscheidung eines Schottkymetalles zur Bildung eines Schottkykontaktes auf dieser ab, da die erzielbare Qualität des Schottkykontaktes entscheidend von der Güte des Metall-Halbleiter-Überganges beeinflusst wird. Die Höhe der Potentialbarriere am Übergang zwischen Schottkymetall und Halbleiterkörper, also an der Metall-Halbleiter-Grenzschicht wird in erster Linie durch die folgenden Eigenschaften bestimmt:
- Lage des Ferminiveaus im Halbleiterkörper,
- Lage des Ferminiveaus im Metall des Schottkykontaktes und
- Zustandsdichte an der Grenzfläche zwischen Schottkymetall und Halbleiterkörper.

Die Lage des Ferminiveaus im Halbleiterkörper wird in erster Linie durch dessen Dotierung und Störstellendichte bestimmt, während die Lage des Ferminiveaus im Metall des Schottkykontaktes hauptsächlich von der Art des Metalles abhängig ist. Die Zustandsdichte wird hauptsächlich von der Prozessabfolge während der Herstellung der SiC-Schottkydiode bestimmt.

Es gibt bereits verschiedene Verfahren, die die Ausprägung von bestimmten Potentialbarrieren bei verschiedenen Metallen als Schottkykontakten erlauben. Hierzu gehören u.a. nasschemische Oberflächenvorbereitungen auf dem Halbleiterkörper, eine sogenannte Opferoxidation und eine Temperung bei hohen Temperaturen in verschiedenen Gasatmosphären. Bei allen diesen Verfahren wird eine durch die angewandte Behandlung erreichte Oberflächenmodifikation ausgenutzt, um eine gewünschte Potentialbarriere einzustellen.

Aus der EP 0 518 683 A1 ist es bekannt, bei einem MESFET zur Herstellung eines Gateanschlusses in einer Epitaxischicht aus Siliziumcarbid zunächst eine Vertiefung herzustellen und dann im Bereich dieser Vertiefung zur Herstellung eines Schottky-Kontakts eine Metallisierung aus Platin, Platinsilizid oder Gold aufzubringen.

Aus S.M. Tang et al: "Titanium Silicide Ohmic Contacts for high Temperature S-SiC Devices", Extended Abstracts, US, Electrochemical Society, Princeton, New Jersey, Bd. 88-2, 21. September 1988, Seite 680, ist es bekannt, n-dotiertes Siliziumcarbid unmittelbar vor dem Aufbringen einer Metallisierung mit HF zu ätzen, um jegliches Oberflächenoxid zu entfernen.

Der vorliegenden Erfindung liegt daher die Aufgabe zugrunde, ein Verfahren anzugeben, mittels dem die Qualität von Metallschichten auf epitaktisch hergestellten SiC-Halbleiterschichten verbessert wird.

Diese verfahrensbezogene Aufgabe wird erfindungsgemäß durch das Verfahren mit den Merkmalen von Patentanspruch 1 gelöst.

Im Sinne von Anspruch 1 ist unter einem Abtragungsprozess bzw. unter einem Abtragen einer Schicht von der Oberfläche ein vollständiges Ablösen dieser Schicht zu verstehen, so dass die soeben abgetragene Schicht nicht mehr mit dem Halbleiterkörper in Verbindung steht. Ein Oxidationsprozess, bei dem im weiteren Sinn auch ein Teil der an die Oberfläche grenzenden Bereiche des Halbleiterkörpers "abgetragen" wird, ist hiermit nicht gemein, da die durch Oxidation "abgetragenen" Bereiche bekanntlich noch Teil des Halbleiterkörpers sind bzw. an diesem haften und erst durch einen zusätzlichen im Allgemeinen nasschemischen Ätzprozess von diesem abgelöst werden.

Die beim erfindungsgemäßen Verfahren sich anschließende nasschemische Behandlung dient hier dem Ablösen eines dünnen natürlichen Oxides, welches sich nach einer gewissen Zeit bei Silizium enthaltenden Halbleiterkörpern unerwünschterweise ausbildet. Die Dicke dieses dünnen Oxids bewegt sich im Allgemeinen im Bereich von einigen wenigen Nanometern.

Die Erfindung geht dabei von der vorliegenden Erkenntnis aus:

Die Epitaxie stellt einen "Nichtgleichgewichtsprozess" dar, der sich in drei Phasen, nämlich eine Keimphase zu Beginn des epitaktischen Wachstums, eine Fließgleichgewichtsphase während des epitaktischen Wachstums und eine Schlussphase während des Abschaltens der Epitaxie unterteilen lässt. In der Schlussphase werden dabei die für die Epitaxie erforderlichen Prozessgase zwar makroskopisch abgeschaltet. Die Gaskonzentration im Epitaxiereaktor fällt nach diesem Abschalten jedoch nur vergleichsweise langsam mit der Zeit ab, so dass sogar in der anschließenden Abkühlphase noch Reste der verschiedenen Gase vorhanden sein können. Beispielsweise werden für die Erzeugung einer n⁻-leitenden epitaktischen Schicht SiH₄ (Silan), C₃H₈ (Propan) und N₂ (als Dopand) bei der Reaktion verwendet. Entsprechend kann auch die Konzentration dieser Reaktionsteilnehmer schwanken, wenn z.B. die drei Gasströmungskontroller in bestimmter Reihenfolge geschlossen werden. Insgesamt führt dies nun dazu, dass der Zustand der Oberfläche des Halbleiterkörpers nicht hinreichend genau kontrollierbar ist.

Um nun diese Schwierigkeit zu überwinden, wird bei der vorliegenden Erfindung aus der Wachstumsrate r der Epitaxie und der Zeitdauer T der oben genannten Schlussphase des Epitaxieprozesses eine Dicke D einer Schicht bestimmt, welche durch geeignete Ätzmethoden abgetragen werden muss, um so die "ungestörten" Schichten der Fließgleichgewichtsphase freizulegen. Die Schichtdicke D ist dabei durch das Produkt der Wachstumsrate r mit der Zeitdauer T bestimmt und beträgt beispielsweise bei einer Wachstumsrate von 3 µm/H und einer Schlussphase von beispielsweise 1,5 min optimalerweise 75 nm.

In vorteilhafter Weise kann einem solchen Abtrag noch ein Aufschlag von 10 %, höchstens 50 %, beigemessen werden, um Unsicherheiten in der Bestimmung der Wachstumsrate r, der Reaktor-Abschaltzeit und den Ätzraten des Abtragungsprozesses entgegenzuwirken.

Geeignete Verfahren zum Ätzen von SiC sind insbesondere Trockenätzverfahren, wie RIE (reaktives Ionenätzen), IBE (Ionenstrahlätzen) oder Ätzverfahren in der Gasphase.

Besonders vorteilhaft ist nicht zuletzt im Hinblick auf die Integration dieses Ätzschrittes in die Prozessabfolge zur Herstellung der Schottkydiode ein RIE-Verfahren in einem Gasgemisch aus fluorhaltigen Gasen und Sauerstoff, da hier der Fluoranteil mit dem Silizium des Halbleiterkörpers zu flüchtigen Fluoridverbindungen reagiert und der Sauerstoffanteil den Kohlenstoff des Halbleiterkörpers oxidiert.

Einem derartigen Gasgemisch kann in vorteilhafter Weise auch noch ein chemisch inertes Gas, wie beispielsweise Argon oder Helium, beigemischt werden, um den physikalischen Abtrag geringfügig zu erhöhen bzw. um Redepositionseffekten an strukturierten Oberflächenteilen von Schottkydioden vorzubeugen.

Bei der Prozessführung ist es vorteilhaft, die Leistungsdichte und die sich im Reaktor einstellende Biasspannung bzw. Substratvorspannung möglichst klein zu halten. Diese Biasspannung wird durch Selbstladung des Substrathalters in einem mit Hochfrequenz angeregten Plasma hervorgerufen.

Mit dem erfindungsgemäßen Verfahren kann ein Abtragungsprozess beispielsweise in einem Planarreaktor vorgenommen werden, wenn in einem Gasgemisch aus 50 cm³ SF₆, 10 cm³ O₂ und 5 cm³ Ar bei einem Gasdruck von 2,8 Pa (28 *µ*bar) ein Plasma mit einer Leistungsdichte von 0,4 W/cm² bei einer Bias- bzw. Substratvorspannung von -260 V gezündet wird. Nach einem solchen RIE-Verfahren ist durch eine nasschemische Behandlung direkt vor der Metallisierung sicherzustellen, dass die Oberfläche von Siliziumdioxid befreit ist. Dies wird in vorteilhafter Weise durch ein Eintauchen in gepufferte Flusssäure "BHF-Dip" während ca. 5 min mit einem anschließenden Spülen in Reinstwasser und Trocknen erreicht. Unmittelbar anschließend wird dann zweckmäßigerweise die Metallisierung durch Sputtern oder Aufdampfen aufgetragen.

Durch das Abtragen der während der Schlussphase eines Epitaxieprozesses erzeugten Teile einer epitaktischen Schicht werden die folgenden, wesentlichen Vorteile erzielt:

Das Beenden eines epitaktischen Wachstums ist ein an sich schwer kontrollierbarer und beherrschbarer Prozess, so dass keinesfalls sichergestellt ist, dass die obersten Atomlagen der epitaktischen Schicht die gleichen Materialeigenschaften speziell hinsichtlich Dotierung und Defektdichte haben, wie das darunter liegende, während der Fließgleichgewichtsphase kontinuierlich gewachsene Volumen der epitaktischen Schicht. Dieser durch den schwer kontrollierbaren Prozess bedingte "Unsicherheitsfaktor" wird durch das Abätzen der obersten Teile der epitaktischen Schicht, die während der Schlussphase aufgewachsen sind, beseitigt. Für dieses Abätzen kann, wie oben erläutert wurde, beispielsweise ein RIE- oder ein IBE-Prozess zur Anwendung gelangen.

Jedenfalls wird durch das Abtragen Prozess-Sicherheit für die folgenden Schritte erreicht, so dass diese auch von der Prozessführung bei der Epitaxie unabhängig werden.

Der Abtragungsprozess der obersten Teile der epitaktischen Schicht durch Ätzen führt zu einer sehr stabilen Oberfläche des Halbleiterkörpers aus SiC, wie zahlreiche Versuche der Erfinder gezeigt haben, und zu einer in hohem Maße reproduzierbaren Zustandsdichte.

Damit ist es möglich, mittels des erfindungsgemäßen Verfahrens eine Schottkydiode herzustellen, bei der eine nur von der Wahl des jeweiligen Schottkymetalles abhängige Barrierenhöhe reproduzierbar eingestellt werden kann.

Es ist aber zu betonen, dass mit dem erfindungsgemäßen Verfahren ohne weiteres auch hervorragende ohmsche Kontakte auf epitaktischen Schichten hergestellt werden können.

Das erfindungsgemäße Verfahren, bei dem die während der Schlussphase erzeugten Teile einer epitaktischen Schicht durch Ätzen abgetragen werden, kann in vorteilhafter Weise in nahezu jeder Prozessabfolge zur Herstellung eines Halbleiterbauelementes angewandt werden. Beispielsweise können vor einer Metallisierung umfangreiche Implantationsschritte, um etwa p-leitende implantierte Bereiche zu erzeugen, und Temperschritte zur Aktivierung implantierter Atome erforderlich sein. In solchen Fällen wird zweckmäßigerweise die Abtragung der während der Schlussphase der Epitaxie erzeugten obersten Teile einer epitaktischen Schicht erst unmittelbar vor der jeweils anstehenden Metallisierung vorgenommen. Hierbei ist - bei der Auslegung der Implantationsprofile - dann allerdings der erforderlich Abtrag so zu berücksichtigen, dass die Implantationstiefe um diesen Abtrag erhöht ist oder - falls die Implantationsenergie nicht ausreichen sollte - die Implantationskonzentration hinsichtlich der erforderlichen Flächenladung um einem dem Abtrag entsprechenden Anteil erhöht ist.

Sollte der erforderliche Abtrag der in der Schlussphase erzeugten Teile der epitaktischen Schicht in den Bereich der maximal möglichen Reichweite von implantierten Ionen, der einige 100 nm beträgt, kommen, so ist es von Vorteil, den Ätzprozess aufzuteilen: Beispielsweise ergibt sich mit einer Wachstumsrate von 10 µm/h und einer Abschaltzeit von etwa 1,5 min ein erforderlicher Abtrag von wenigstens 250 nm. Um nun die Ionen ausreichend tief implantieren zu können, wird hier direkt nach der Epitaxie eine Schicht mit einer Dicke von etwa 180 nm abgetragen. Die verbleibende Schicht mit einer Schichtdicke von 70 nm wird sodann erst nach der Ionenimplantation entfernt. Eine solche "Zweiteilung" hat den Vorteil, dass einerseits die Teile der epitaktischen Schicht, die während der Schlussphase der Epitaxie aufgetragen sind, eliminiert werden, und dass andererseits Defektkonzentrationsänderungen, die durch die Prozessfolge, wie beispielsweise eine Ionenimplantation oder Temperschritte induziert sind, verhindert werden.

Besonders vorteilhaft ist es, wenn der Halbleiterkörper bei der Herstellung der Schottky-Kontakte, dass heißt während der Abscheidung des Metalls, des Silizides oder eines ähnlichen Materials, einer erhöhten Temperatur unterworfen wird, da dadurch die Oberfläche von Flüssigkeitsrückständen befreit wird und somit ein besserer Kontakt möglich ist. Besonders vorteilhaft ist es, wenn diese erhöhte Temperatur größer als 100°C ist, wenngleich auch niedrigere Temperaturen bereits deutlich verbesserte Effekte liefern. Selbstverständlich lässt sich dieses Verfahren auch als Vorbereitung zur Herstellung ohmscher Kontakte vorteilhaft einsetzen.

Insgesamt ermöglicht so das erfindungsgemäße Verfahren eine Reihe von wesentlichen Vorteilen:

Der Ätzprozess führt zu einer stabilen Oberfläche des aus Siliziumcarbid bestehenden Halbleiterkörpers und zu einer in hohem Maße reproduzierbaren Zustandsdichte. Damit kann eine von der Wahl des jeweiligen Schottkymetalles abhängige Barrierenhöhe reproduzierbar eingestellt werden. Gleiches gilt auch in entsprechender Weise für die Herstellung von ohmschen Kontakten.

Die Oberfläche des Halbleiterkörpers aus Siliziumcarbid wird durch die Abtragung durch Ätzen gereinigt. Mit anderen Worten, die Konzentration an Fremdatomen, die gegebenenfalls die Höhe der Schottky-Potenzialbarriere verändern könnten, nimmt ab.

Nachteilhafte Folgen der schwer beherrschbaren und kontrollierbaren Schlussphase des epitaktischen Prozesses sind eliminiert.

Bei dem erfindungsgemäßen Verfahren wird vor der Metallisierung mit dem Schottkymetall durch eine nasschemische Behandlung das natürliche Oxid (Siliziumdioxid) entfernt. Im Falle der Herstellung von Schottkydioden können dann unverzüglich Metalle, wie beispielsweise Wolfram, Tantal, Titan usw. durch Sputtern oder Dampfen abgeschieden werden. Im Falle des Sputterns sollte darauf geachtet werden, dass zumindest zu Beginn des Sputterprozesses die Leistungsdichte bei verschwindender Vorspannung (insbesondere 0 V) gering gehalten wird. Nach Abscheidung der ersten Atomlagen kann dann die Leistungsdichte erhöht werden, wobei auch die Vorspannung zunehmen kann.

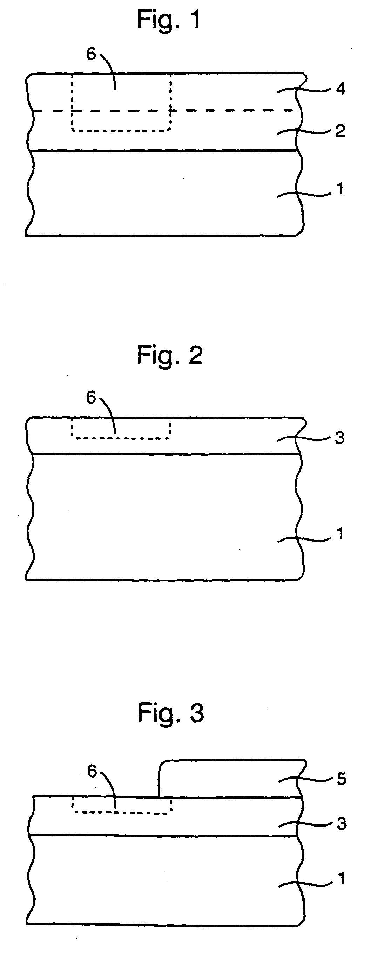

Nachfolgend wird die Erfindung anhand der Zeichnungen näher erläutert, in deren Fig. 1 bis 3 schematisch verschiedene Schritte des erfindungsgemäßen Verfahrens gezeigt sind.

Auf einem SiC-Halbleiterkörper 1 befindet sich eine epitaktisch abgeschiedene SiC-Schicht 2. Der während der Schlussphase der Epitaxie erzeugte Teil dieser Schicht 2 liegt oberhalb einer Strichlinie und ist mit Bezugszeichen 4 versehen.

An dieser Stelle kann eine lokale Ionenimplantation vorgenommen werden, wie sie zum Beispiel zum Herstellen eines implantierten Bereiches 6 als bipolarer Randabschluss der Schottkydiode notwendig ist.

Nach einer Temperung zum Ausheilen der implantierten Ionen und anschließende Reinigung der in Fig. 1 gezeigten Anordnung wird der Teil 4 der epitaktischen Schicht 2 durch RIE entfernt. Sodann wird eine nasschemische Behandlung vorgenommen. Damit liegt die in Fig. 2 gezeigte Anordnung vor, bei der eine in der Schichtdicke reduzierte epitaktische Schicht 3 auf dem Halbleiterkörper 1 vorgesehen ist.

Es schließt sich sodann ein Metallisieren mit Wolfram, Titan oder Tantal usw. durch Sputtern oder Dampfen an.

Anschließend wird eine Wärmebehandlung (RTP = Rapid Thermal Processing; rasches thermisches Behandeln) bei beispielsweise 400°C oder 800 bis 900°C vorgenommen. Auf diese Weise wird die in Fig. 3 gezeigte Anordnung erhalten, bei der ein Schottkykontakt 5 auf der epitaktischen Schicht 3 vorgesehen ist.

Typische Barrierehöhen φ_{B} liegen für Wolfram bei 1,1 eV nach Temperung bzw. RTP bei 400°C und über 1,1 eV nach RTP bei 800 bis 900°C. Für Titan liegt die Barrierehöhe φ_{B} bei 1,15 eV oder darüber, wenn zwischen der Temperung oder implantierten Bereiche und der Reinigung nach obigem Verfahren noch ein Wasserstoffätzen eingeführt wird (nach RTP bei 400°C).

Allgemein sind die Barrierenhöhen eines Schottky-Übergangs mittels Strom-Spannungsmessungen in Flussrichtung zu bestimmen. Die ermittelte Barrierenhöhe und die Messwerte müssen dabei im Temperaturbereich zwischen -50°C und 150°C mit der theoretischen Beschreibung durch die thermionische Emission nach R.H. Rhoderick, R.H. Williams, Metall-Semiconductor Contacts, Oxford University Press 1988, Seite 96, Gleichung (3.10) übereinstimmen. Eine Übereinstimmung ist gegeben, wenn die Standardabweichung des Logarithmus des theoretischen Stroms in Ampere vom Logarithmus des gemessenen Stroms in Ampere unter 0,1 liegt, und zwar in dem Kurvenbereich in dem der gemessene Strom vom Schottky-Effekt dominiert wird. Die Idealität und die Richardson-Konstante ergeben sich aus den Strom-Spannungs-Messwerten bei verschiedenen Temperaturen. Damit werden erhalten:

| Metall | Barriere | Idealität | bei Dotierung |
|---|---|---|---|
| Titan | > 1,20 eV | < 1,07 | 5·10¹⁵ cm⁻³ bis 2·10¹⁶ cm⁻³ |
| Wolfram | > 1,05 eV | < 1,07 | 5·10¹⁵ cm⁻³ bis 2·10¹⁶ cm⁻³ |
| Tantal | > 0,95 eV | < 1,08 | 5·10¹⁵ cm⁻³ bis 2·10¹⁶ cm⁻³ |

### Bezugszeichenliste

- 1: Halbleiterkörper
- 2: epitaktische Schicht
- 3: verbleibende epitaktische Schicht
- 4: in Schlussphase der Epitaxie erzeugte Teile der epitak- tischen Schicht
- 5: Metallisierung
- 6: implantierter Bereich

## Patentansprüche

1. Verfahren zur Behandlung einer Oberfläche einer epitaktisch hergestellten SiC-Halbleiterschicht (2, 3, 4) mit folgenden Schritten:
- Epitaktisches Herstellen einer SiC-Halbleiterschicht (2, 3, 4) unter Zufuhr von Prozessgasen;
- Abschalten der Zufuhr der Prozessgase;
- Abtragung einer nach dem Abschalten der Zufuhr der Prozessgase erzeugten Schicht der SiC-Halbleiterschicht;
- Entfernen eines natürlichen Oberflächenoxids mittels einer nasschemischen Behandlung der Oberfläche im Anschluss an den Abtragungsprozess; danach
- Herstellen eines Kontaktes durch Auftragen einer Metallschicht (5) auf die Oberfläche der SiC-Halbleiterschicht (2, 3, 4).

2. Verfahren nach Anspruch 1,
**dadurch gekennzeichnet,**
**dass** nach der nasschemischen Behandlung die Metallschicht (5) zur Ausbildung eines Schottkykontaktes oder eines ohmschen Kontaktes auf die Oberfläche aufgetragen wird.

3. Verfahren nach einem oder mehreren der vorstehenden Ansprüche,
**dadurch gekennzeichnet,**
**dass** für den Abtragungsprozess ein Trockenätzprozess oder ein Gasphasenätzprozess verwendet wird.

4. Verfahren nach einem oder mehreren der vorstehenden Ansprüche,
**dadurch gekennzeichnet, dass**
für die Metallschicht (5) zumindest teilweise eine Legierung aus Titan und/oder Tantal und/oder Wolfram verwendet wird.

5. Verfahren nach einem von Anspruch 3 abhängigen Anspruch,
**dadurch gekennzeichnet, dass**
als Trockenätzen ein reaktives Ionenätzen und/oder ein Ionenstrahlätzen angewendet wird.

6. Verfahren nach Anspruch 5,
**dadurch gekennzeichnet,**
**dass** für das reaktive Ionenätzen ein Gasgemisch aus fluorhaltigen Gasen, und Sauerstoff verwendet wird.

7. Verfahren nach Anspruch 6,
**dadurch gekennzeichnet,**
**dass** das Gasgemisch ein inertes Gas enthält.

8. Verfahren nach Anspruch 6 oder 7,
**dadurch gekennzeichnet,**
**dass** das fluorhaltige Gas SF₆ ist.

9. Verfahren nach einem oder mehreren der vorstehenden Ansprüche,
**dadurch gekennzeichnet,**
**dass** der Abtragungsprozess in wenigstens zwei Stufen vorgenommen wird.

10. Verfahren nach Anspruch 9,
**dadurch gekennzeichnet,**
**dass** zwischen den wenigstens zwei Stufen eine Ionenimplantation mit nachfolgender Ausheilung durchgeführt wird.

11. Verfahren nach einem oder mehreren der vorstehenden Ansprüche,
**dadurch gekennzeichnet,**
**dass** das Material für einen Schottky-Kontakt oder einen ohmschen Kontakt auf die Oberfläche der SiC-Halbleiterschicht bei erhöhter Temperatur aufgebracht wird.

12. Verfahren nach Anspruch 11,
**dadurch gekennzeichnet,**
**dass** die erhöhte Temperatur mehr als 100°C beträgt.

13. Verfahren nach einem der Ansprüche 1 bis 12, bei dem die Metallschicht (5) Wolfram und/oder Titan und/oder Tantal enthält und mit der SiC-Halbleiterschicht (2, 3, 4) einen Schottky-Metall Halbleiterkontakt bildet, der nach einem bei einer Temperatur von 400°C vorgenommenen RTP-Schritt (RTP = rapid thermal processing) eine Barrierehöhe im Fall von Wolfram von über 1,05 eV, im Fall von Titan von über 1,15 eV, und im Fall von Tantal von über 0,95 eV aufweist.

## Claims

1. Method for processing a surface of an epitaxially fabricated SiC semiconductor layer (2, 3, 4), having the following steps:
- epitaxially fabricating an SiC semiconductor layer (2, 3, 4) with supply of process gases;
- turning off the supply of process gases;
- removing a layer of the SiC semiconductor layer that is produced after turning off the supply of process gases;
- removing a natural surface oxide by means of a wet-chemical processing of the surface after the removal process; then
- producing a contact by applying a metal layer (5) to the surface of the SiC semiconductor layer (2, 3, 4).

2. Method according to Claim 1,
**characterized**
**in that**, after the wet-chemical processing, the metal layer (5) for the formation of a Schottky contact or of an ohmic contact is applied to the surface.

3. Method according to one or more of the preceding claims,
**characterized**
**in that** a dry etching process or a gas phase etching process is used for the removal process.

4. Method according to one or more of the preceding claims,
**characterized in that**
at least in part an alloy comprising titanium and/or tantalum and/or tungsten is used for the metal layer (5).

5. Method according to a claim dependent on Claim 3
**characterized in that**
a reactive ion etching and/or an ion beam etching is employed as dry etching.

6. Method according to Claim 5,
**characterized**
**in that** a gas mixture comprising fluorine-containing gases, and oxygen is used for the reactive ion etching.

7. Method according to Claim 6,
**characterized**
**in that** the gas mixture contains an inert gas.

8. Method according to Claim 6 or 7,
**characterized**
**in that** the fluorine-containing gas is SF₆.

9. Method according to one or more of the preceding claims,
**characterized**
**in that** the removal process is performed in at least two stages.

10. Method according to Claim 9,
**characterized**
**in that** an ion implantation with subsequent annealing is carried out between the at least two stages.

11. Method according to one or more of the preceding claims,
**characterized**
**in that** the material for a Schottky contact or an ohmic contact is applied to the surface for the SiC semiconductor layer at elevated temperature.

12. Method according to Claim 11,
**characterized**
**in that** the elevated temperature is more than 100°C.

13. Method as claimed in one of Claims 1 to 12,
in which the metal layer (5) contains tungsten and/or titanium and/or tantalum and forms a Schottky contact with the SiC semiconductor layer (2, 3, 4) which contact has a barrier height after an RTP step (RTP = rapid thermal processing) performed at a temperature of 400°C, of above 1.05 eV in the case of tungsten, of above 1.15 eV in the case of titanium, and above 0.95 eV in the case of tantalum.

## Revendications

1. Procédé de traitement d'une surface d'une couche (2, 3, 4) semi-conductrice en SiC produite par épitaxie comprenant les stades dans lesquels :
- on produit par épitaxie une couche (2, 3, 4) semi-conductrice en SiC avec apport de gaz de processus ;
- on interrompt l'apport des gaz de processus ;
- on enlève de la couche semi-conductrice en SiC une couche produite après l'arrêt de l'apport des gaz de processus ;
- on élimine un oxyde superficiel naturel au moyen d'un traitement chimique en voie humide de la surface à la suite de l'opération d'enlèvement ; ensuite
- on produit un contact par dépôt d'une couche (5) métallique sur la surface de la couche (2, 3, 4) semi-conductrice en SiC.

2. Procédé suivant la revendication 1, **caractérisé en ce qu'**après le traitement chimique en voie humide, on dépose sur la surface la couche (5) métallique pour la production d'un contact de Schottky ou d'un contact ohmique

3. Procédé suivant l'une ou plusieurs des revendications précédentes, **caractérisé en ce qu'**on utilise, pour l'opération d'enlèvement, une opération d'attaque à sec ou une opération d'attaque en phase gazeuse.

4. Procédé suivant l'une ou plusieurs des revendications précédentes, **caractérisé en ce qu'**on utilise, pour la couche (5) métallique, au moins en partie un alliage de titane et/ou de tantale et/ou de tungstène.

5. Procédé suivant l'une des revendications dépendantes de la revendication 3, **caractérisé en ce qu'**on applique, comme attaque à sec, une attaque par des ions réactifs et/ou une attaque par un faisceau d'ions.

6. Procédé suivant la revendication 5, **caractérisé en ce qu'**on utilise, pour l'attaque par ions réactifs, un mélange gazeux de gaz fluorés et d'oxygène.

7. Procédé suivant la revendication 6, **caractérisé en ce que** le mélange gazeux contient un gaz inerte.

8. Procédé suivant la revendication 6 ou 7, **caractérisé en ce que** le gaz fluoré est du SF₆.

9. Procédé suivant l'une ou plusieurs des revendications précédentes, **caractérisé en ce qu'**on effectue le processus d'enlèvement en au moins deux étapes.

10. Procédé suivant la revendication 9, **caractérisé en ce qu'**on effectue une implantation d'ions avec réparation venant ensuite entre les au moins deux étapes.

11. Procédé suivant l'une ou plusieurs des revendications précédentes, **caractérisé en ce qu'**on dépose la matière pour un contact de Schottky ou pour un contact ohmique à la surface de la couche semi-conductrice en SiC en opérant à une température plus élevée.

12. Procédé suivant la revendication 11, **caractérisé en ce que** la température plus élevée est supérieure à 100°C.

13. Procédé suivant l'une des revendications 11 à 12, dans lequel la couche (5) métallique contient du tungstène et/ou du titane et/ou du tantale et forme, avec la couche (2, 3, 4) semi-conductrice en SiC, un contact métallique de Schottky qui, après un stade RTP (RTP = rapid thermal processing) effectué à une température de 400°C, a un niveau de barrière dans le cas du tungstène de plus de 1,05 eV, dans le cas du titane de plus de 1, 15 eV et dans le cas du tantale de plus de 0,95 eV.
